(19) **Europäisches Patentamt / European Patent Office / Office européen des brevets**

(11) **EP 2 105 958 B1**

(12) **FASCICULE DE BREVET EUROPEEN**

(45) Date de publication et mention
de la délivrance du brevet:
**06.07.2011  Bulletin 2011/27**

(51) Int Cl.:
***H01L 21/762*** *(2006.01)*

(21) Numéro de dépôt: **09155871.8**

(22) Date de dépôt: **23.03.2009**

(54) **Procédé de réalisation d'une couche contrainte**

Verfahren zur Herstellung einer vorgespannten Schicht

Method for manufacturing a stressed layer

(84) Etats contractants désignés:
**AT BE BG CH CY CZ DE DK EE ES FI FR GB GR HR HU IE IS IT LI LT LU LV MC MK MT NL NO PL PT RO SE SI SK TR**

(30) Priorité: **28.03.2008  FR 0852034**

(43) Date de publication de la demande:
**30.09.2009  Bulletin 2009/40**

(73) Titulaire: **Commissariat à l'Énergie Atomique et aux Énergies Alternatives
75015 Paris (FR)**

(72) Inventeurs:
• **Deguet, Chrystel
38330, SAINT ISMIER (FR)**
• **Fournel, Frank
38190, VILLARD-BONNOT (FR)**

(74) Mandataire: **Ilgart, Jean-Christophe et al
BREVALEX
95 rue d'Amsterdam
75378 Paris Cedex 8 (FR)**

(56) Documents cités:
**WO-A-98/54766        WO-A-03/030215
WO-A-2006/097522     US-A1- 2003 199 105
US-A1- 2004 229 444**

**Description**

**DOMAINE TECHNIQUE ET ART ANTERIEUR**

L'invention concerne les procédés de réalisation de couches contraintes, notamment du type qui demande une adaptation du paramètre de maille.

Elle s'applique notamment à la fabrication de couches contraintes pour la microélectronique telle que du sSOI (Strained Silicon on Insulator).

De manière connue, le sSOI s'obtient en faisant croître une couche de $Si_{1-x}Ge_x$ (couramment x=0,2) relaxé sur un substrat de silicium, en utilisant éventuellement des couches tampons permettant d'adapter le paramètre de maille.

Ensuite on fait croître une couche de Silicium, très fine pour qu'elle garde le paramètre de maille du SiGe. Dans le cas du $Si_{0,8}Ge_{0,2}$, le Silicium est alors contraint à environ 1.4GPa avec un désaccord paramétrique de 0.7 %. Cette couche de Si contraint peut alors être transférée sur un substrat de silicium oxydé afin de fabriquer un sSOI (Silicium contraint sur isolant ou strained Silicon on insulator).

D'autres techniques existent pour réaliser du sSOI mais, en général, elles font appel à de l'épitaxie, ce qui rend ces techniques assez onéreuses. En outre, il existe toujours un taux assez élevé (supérieur à $10^4/cm^2$) de dislocations dans la couche de silicium contraint.

Document US 2003/0199105 décrit une méthode de transfert d'un substrat piezoélectrique vers un substrat receveur.

**EXPOSÉ DE L'INVENTION**

L'invention concerne un procédé de formation d'une contrainte dans une couche, par exemple en matériau semi-conducteur, comportant :

a) l'assemblage de cette couche avec une première structure, ou des moyens, de mise sous contrainte, comportant au moins un substrat ou une couche apte à se déformer dans son plan sous l'effet d'un champ électrique ou magnétique ou d'un flux de photons,
b) la mise sous contrainte dudit substrat ou de ladite couche par modification du champ électrique ou magnétique ou du flux de photons appliqué à la couche apte à se déformer.

L'invention permet de s'affranchir de l'étape d'hétéroépitaxie, ce qui limite le nombre de dislocations dans la couche contrainte et relâche les limitations sur le choix des matériaux à contraindre.

Selon l'invention, on réalise une couche contrainte en utilisant les propriétés piézoélectriques ou électrostrictives ou magnétostrictives ou photostrictives du substrat ou de la couche de matériau apte à se déformer.

Dans le cas d'une structure de mise sous contrainte avec un matériau piézoélectrique ou électrostrictif, deux électrodes sont disposées de part et d'autre du substrat ou de la couche piézoélectrique ou électrostrictive.

La modification du champ électrique ou magnétique ou du flux de photons appliqué au substrat ou à la couche apte à se déformer pourra être une augmentation (voire la création) ou une diminution (voire la suppression) ou l'inversion dudit champ ou dudit flux appliqué.

La couche à contraindre peut faire initialement partie d'un substrat. Ce substrat est assemblé lors de l'étape a) avec la première structure de mise sous contrainte.

Puis la couche est individualisée ou séparée du reste du substrat par exemple par un amincissement de type mécanique, ou par fracture du substrat le long d'une zone de fragilisation réalisée dans ce substrat (par exemple par implantation d'espèces gazeuses).

En variante, le substrat d'origine peut comporter une couche d'arrêt à la gravure enterrée. Dans ce cas, l'amincissement du substrat d'origine est de type mécanique et/ou chimique jusqu'à atteindre cette couche d'arrêt, qui est ensuite éliminée chimiquement pour laisser subsister la couche à contraindre.

Un procédé selon l'invention peut comporter :

- avant l'étape a), une précontrainte, par mise sous contrainte de la première structure de mise sous contrainte, de signe opposé à la contrainte que l'on souhaite appliquer à la couche à contraindre,
- après l'étape a), une relaxation de la précontrainte, pour contraindre la couche à contraindre.

Une mise sous contrainte préalable du substrat ou de la couche apte à se déformer permet de générer ou d'augmenter la contrainte de la couche à contraindre.

Avantageusement, on peut ensuite appliquer à la couche ainsi contrainte, une contrainte supplémentaire par modification du champ électrique ou magnétique ou du flux de photons appliqué à la couche apte à se déformer.

Avantageusement, la couche contrainte pourra être assemblé, avec un substrat ou une couche de report. Dans la suite du texte, on utilise indifféremment les deux expressions « substrat» et « couche» quelle que soit l'épaisseur de l'élément concerné.

On peut ainsi mettre une couche sous contrainte avant assemblage avecun substrat final.

On peut, ainsi, réaliser par exemple un substrat de type sSOI.

Après collage de la couche contrainte sur le substrat de report, la structure de mise sous contrainte peut être totalement ou partiellement éliminée.

Avantageusement, l'assemblage de ladite couche à contraindre avec la structure de mise sous contrainte est d'énergie plus faible que l'énergie de l'assemblage entre la couche contrainte et le substrat de report.

On peut ainsi aisément désolidariser la couche mince lors du report sur le substrat de report.

Le deuxième substrat peut être ou faire partie d'une deuxième structure de mise sous contrainte. Il est alors possible, après assemblage avec ce substrat de report, de réaliser une mise sous contrainte supplémentaire de ladite couche contrainte par la première ou par cette deuxième structure de mise sous contrainte.

En variante, après l'étape d'assemblage avec le deuxième substrat, un procédé selon l'invention peut comporter ensuite :

a') un assemblage de la couche contrainte, depuis le substrat de report vers la première ou vers une deuxième structure de mise sous contrainte,

b') une mise sous contrainte supplémentaire de ladite couche contrainte par la première ou par cette deuxième structure de mise sous contrainte.

Lors de l'étape a', l'assemblage de la couche contrainte peut consister en un premier assemblage de la couche contrainte avec une poignée temporaire puis un deuxième assemblage de la couche contrainte sur la structure de mise sous contrainte ; Dans ce cas, la structure de mise sous contrainte peut être celle déjà utilisée lors des étapes a) et b).

Plus généralement, un procédé selon l'invention peut comporter :

a') un assemblage de la couche contrainte, après une première mise sous contrainte par application des étapes a) et b), depuis la première structure de mise sous contrainte vers une deuxième structure de mise sous contrainte,

b') une mise sous contrainte supplémentaire de ladite couche contrainte par cette deuxième structure de mise sous contrainte.

Il peut y avoir, là encore, un assemblage de ladite couche contrainte sur un autre substrat d'assemblage.

La deuxième structure de mise sous contrainte peut comporter au moins un substrat ou une couche apte à se déformer dans son plan sous l'effet d'un champ électrique ou magnétique ou d'un flux de photons. Dans le cas de l'étape b'), celle-ci peut alors comporter la mise sous contrainte de ladite couche par modification du champ électrique ou magnétique ou du flux de photons appliqué au substrat ou à la couche apte à se déformer de la deuxième structure de mise sous contrainte.

Ainsi, quel que soit le mode de réalisation du procédé selon l'invention, une réitération de ce procédé peut être réalisée.

Une ou plusieurs des étapes d'assemblage, notamment lors de l'étape a), peut être de type collage moléculaire, mais d'autres types de collage sont possibles (par exemple à l'aide d'une colle ou d'un polymère).

Le substrat ou la couche apte à se déformer peut être épais, typiquement d'épaisseur supérieure à 200 microns ou comprise entre 200 $\mu$m et 500 $\mu$m ou 1 mm.

Il peut s'agir également d'une couche mince, d'épaisseur inférieure à 200 $\mu$m, voire inférieure à 50 $\mu$m ou comprise entre 1 $\mu$m et 50 $\mu$m ou 200 $\mu$m.

La structure de mise sous contrainte (comportant la couche apte à se déformer) peut également comporter des films facilitant le collage de la couche à contraindre et/ou l'application de la sollicitation sur la couche apte à se déformer.

Le collage moléculaire de la couche à contraindre avec la structure de mise sous contrainte peut se faire directement sur la couche apte à se déformer ou sur une électrode.

En variante, pour faciliter le collage moléculaire et/ou l'application de la sollicitation, un film peut être disposé sur la couche apte à se déformer ou sur l'électrode et/ou sur la couche à contraindre : ce film est par exemple une couche diélectrique (de nitrure ou d'oxyde de silicium par exemple).

Une couche intermédiaire, par exemple une couche épaisse en $SiO_2$, ou en Ge, ou en $Si_3N_4$, ou en $HF0_2$, peut être formée sur une électrode avec laquelle, ou sur le substrat ou la couche avec lequel ou laquelle, est assemblée la couche à contraindre. La couche intermédiaire peut présenter une rugosité sur sa face destinée à être assemblée avec la couche à contraindre.

## BRÈVE DESCRIPTION DES DESSINS

- Les figures 1A à 1C représentent un procédé d'assemblage d'une couche à contraindre sur un substrat à base de matériau piézoélectrique.
- La figure 2 représente une couche à contraindre sur un substrat à base de matériau piézoélectrique sur lequel on applique une différence de potentiel, induisant une déformation dans son plan du matériau et donc de la couche à contraindre.
- La figure 3 représente une étape de transfert, sur un substrat de report, d'une couche contrainte.
- La figure 4 représente une couche à contraindre sur une couche en matériau piézoélectrique, mis sous tension.
- Les figures 5-7 représentent des étapes de réalisation d'un procédé selon l'invention.
- Les figures 8A-8C représente un procédé d'assemblage d'une couche à contraindre issue d'un substrat avec couche d'arrêt.
- Les figures 9 et 10 représentent des autres modes de réalisation d'un procédé selon l'invention.

## EXPOSÉ DÉTAILLÉ DE MODES DE RÉALISATION PARTICULIERS

Un procédé selon l'invention met en oeuvre un substrat en un matériau piézoélectrique ou électrostrictif ou magnétostrictif ou photostrictif. L'invention va être décrite ci-dessous dans le cas d'un substrat piézoélectrique.

Dans la suite, on fait mention du procédé de fracture de substrat « Smart Cut™ ». Ce procédé est décrit par exemple dans l'article de B. Aspar et A.J. Auberton-Hervé « Silicon Wafer Bonding Technology for VLSI and MEMS applications », edited by S.S. Iyer and A.J. Auberton-Hervé, 2002, INSPEC, London, Chapter 3, pages 35-52.

Dans la suite, il est également fait référence au collage moléculaire encore appelé collage direct. Ce sera plus particulièrement le cas pour l'assemblage du substrat dont résulte la couche à mettre sous contrainte et de la structure de mise sous contrainte. Cette technique d'assemblage est décrite notamment par Q.Y. Tong dans « Silicon Wafer Bonding Technology for VLSI and MEMS applications », Edited by S.S. Iyer et A.J. Auberton-Hervé, 2002, INSPEC, London, Chapter 1, pages 1 - 20.

Préalablement à un tel assemblage, des étapes de préparation des surfaces à assembler peuvent être réalisées, telles que dépôt de couches de collage et/ou polissage et/ou nettoyage et/ou traitement plasma, pour permettre un collage avec une énergie de collage contrôlée (forte ou faible selon les cas).

Les faces à coller peuvent être planarisées et préparées pour le collage moléculaire pour les rendre notamment hydrophiles ou hydrophobes.

Un traitement thermique peut ensuite être appliqué en vue de renforcer l'énergie de collage. Selon la nature des substrats présents, le traitement thermique peut être réalisé entre 20°C et 1200°C pendant quelques dizaines de minutes à quelques heures, selon, également, la compatibilité des couches.

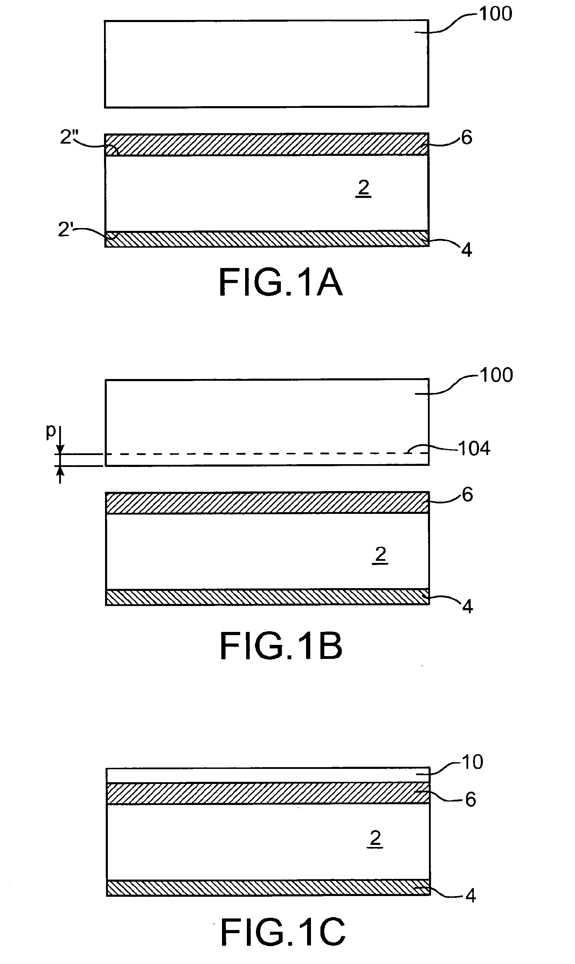

Dans un premier mode de réalisation, on réalise une structure comportant un substrat 2 en un matériau piézoélectrique, illustré sur la figure 1A, présentant deux faces 2', 2" et muni, sur chacune de ces faces, d'une électrode métallique 4, 6. Le matériau piézoélectrique est par exemple choisi parmi la Berlinite (AlP04), l'oxyde de Zinc (ZnO), le Quartz, le Topaze, l'orthophosphate de Gallium (cristal GaPO4), le Langasite (La3Ga5SiO14) le titanate de Barium (cristal BaTi03), ou le titanate de Plomb (PbTiO3), ou le zirconate titanate de Plomb (Pb(ZrTi)O3) (PZT), ou le niobate de Potassium (KNb03), ou le niobate de Lithium (LiNbO3), ou le tantalate de Lithium (LiTaO3), ou le tungstate de Sodium (NaxWO3), ou le Ba2NaNb5O5, ou le Pb2KNb5O15.

Un substrat initial 100 est mis en contact et assemblé, par exemple par collage moléculaire, avec la surface libre de l'une des deux électrodes associées au matériau piézoélectrique -ici l'électrode 6-directement ou par l'intermédiaire d'une couche de collage, par exemple une couche mince de $SiO_2$ ou de $Si_3N_4$.

Après cet assemblage, le substrat 100 est aminci, par exemple par polissage mécano-chimique. On obtient alors une couche 10 du matériau du substrat 100, reportée sur cette même électrode 6 (figure 1C).

En variante (figure 1B), l'amincissement peut être obtenu par fracture le long d'une zone enterrée fragile du substrat 100, par exemple une zone poreuse ou une zone obtenue par implantation d'une ou plusieurs espèces gazeuses (technologie Smart Cut™). L'obtention d'une couche poreuse est décrite par exemple dans l'article de K. Sataguchi et al. « ESTRAN® by Splitting Porous Si layers », Proceedings of the 9th International Symposium on Silicon-on-Insulator Tech. and Device, 99-3, The Electrochemical Society, Seattle, p. 117-121 (1999)

Dans le cas d'une implantation, le substrat 100 (éventuellement recouvert d'une couche de diélectrique, par exemple de $SiO_2$) est préalablement implanté par des ions et/ou des atomes, à une profondeur moyenne p proche de l'épaisseur souhaitée pour la couche mince 10 de matériau à reporter. Est ainsi formée une zone 104 de fragilisation. Après assemblage avec la surface libre de l'électrode 6, on procède, par exemple par effet thermique et/ou mécanique, à une fracture au niveau de cette zone 104 de fragilisation pour laisser subsister sur l'électrode 6 une couche mince 10 du matériau du substrat 100.

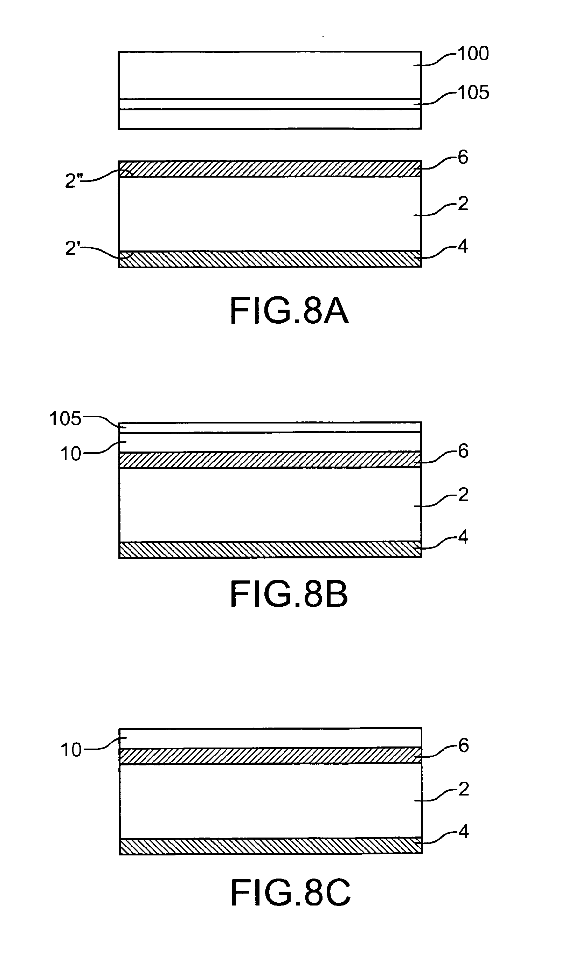

En variante encore, le substrat 100 d'origine peut comporter (figure 8A) une couche d'arrêt enterrée 105 : après assemblage par collage moléculaire avec la surface libre de l'une des deux électrodes associées au matériau piézoélectrique, le substrat est d'abord aminci mécaniquement, puis chimiquement, jusqu'à atteindre cette couche d'arrêt 105(figure 8B). Celle-ci est ensuite éliminée chimiquement, sélectivement par rapport à la couche à contraindre 10 (figure 8C). Cette couche d'arrêt peut être par exemple la couche mince d'oxyde d'un substrat SOI, tandis que le film superficiel 10 de silicium constitue la couche à contraindre.

Dans les trois cas exposés ci-dessus, on assemble, avec l'une des électrodes associées au matériau piézoélectrique -ici l'électrode 6- une couche fine 10 du matériau que l'on souhaite contraindre. Cet assemblage se fait de préférence par collage moléculaire, mais d'autres types de collage sont possibles (par exemple à l'aide d'une colle ou d'un polymère). L'assemblage ou le collage a une énergie suffisamment forte pour assurer l'intégrité de l'assemblage ou du collage pendant la mise sous contrainte du film 10.

L'énergie d'assemblage ou de collage peut être prévue de sorte que la couche 10 puisse par la suite être facilement démontée au niveau de cette interface d'assemblage ou de collage.

En variante, une couche intermédiaire, par exemple une couche épaisse en SiO2, ou en Ge, ou en Si3N4, ou en HfO2 peut être prévue entre la couche 10 de matériau à contraindre et l'électrode 6, pour faciliter le démontage ultérieur de cette couche et de cette électrode, par exemple par gravure sélective.

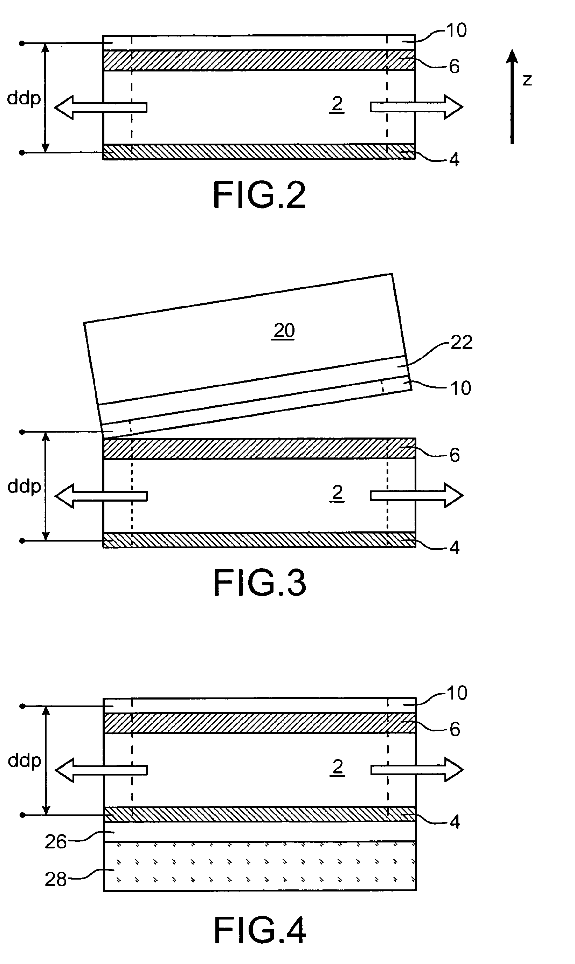

La figure 2 illustre l'effet obtenu sur l'assemblage de la figure 1C lors de l'application d'une différence de potentiel, selon l'axe z, par l'intermédiaire des deux électrodes 4, 6. La tension appliquée permet de créer une déformation du matériau piézoélectrique 2 dans son plan, fonction de la différence de potentiel appliquée, conduisant, dans l'exemple, à la mise en tension de la couche 10.

Cette dernière peut alors être assemblée, par exemple par collage moléculaire, avec un substrat 20 de report (figure 3). La couche 10 peut-être assemblée directement au substrat 20, ou bien elle peut l'être par l'intermédiaire d'une couche 22 par exemple d'oxyde, comme illustré sur la figure 3, ou par l'intermédiaire d'une colle.

Après cet assemblage, la structure (comprenant au moins le substrat piézoélectrique et ses deux électrodes) peut être au moins partiellement éliminée (par exemple par démontage au niveau de l'interface entre la structure et la couche 10).

La différence de potentiel appliquée sur le substrat piézoélectrique 2 par l'intermédiaire des électrodes 4, 6 peut être maintenue pendant tout le procédé de transfert de la couche 10 sur le substrat final 20. En variante, elle n'est appliquée que pendant l'étape d'assemblage avec le substrat final. On obtient ainsi une couche 10 de matériau, assemblée avec un substrat hôte 20 et présentant une contrainte. Par exemple, si on considère l'exemple d'un substrat hôte 20 en silicium, muni d'une couche 22 en oxyde de silicium (qui peut avoir été obtenue par oxydation superficielle du substrat 20), le transfert d'un film mince 10 contraint en silicium permet d'obtenir un substrat de type sSOI.

Il est donc possible d'obtenir un film mince 10 contraint à l'issue d'une seule mise en contrainte sur un substrat 2 en matériau piézoélectrique et d'un seul assemblage avec le substrat 20.

Mais il est également possible de réitérer le procédé, en assemblant de nouveau la couche 10, du substrat 20 avec une structure de mise sous contrainte, le même que lors de la première mise sous contrainte, ou une structure différente, comportant une autre couche en un matériau apte à se déformer dans son plan sous l'effet d'un champ électrique ou magnétique ou encore d'un flux de photons (on décrit plus loin ces modes de déformation).

En variante, la couche contrainte 10 pourrait directement être reportée depuis la première structure de mise sous contrainte vers une deuxième structure de mise sous contrainte. Cette deuxième structure de mise sous contrainte peut être du type de l'une des structures selon la présente invention, telles que celles déjà décrites ci-dessus ou celles décrites ci dessous. En particulier cette deuxième structure de mise sous contrainte peut être similaire ou identique à la première structure.

La première valeur de contrainte, obtenue lors du premier cycle, est alors par exemple, augmentée pour atteindre une deuxième valeur, supérieure à la première valeur. Un tel cycle peut être répété un nombre quelconque de fois, afin d'atteindre un état de contrainte souhaité quelconque.

Cette réitération du procédé peut être, ou non, combinée avec l'application d'une précontrainte ou d'une prédéformation, comme il sera expliqué plus en détail plus loin, en appliquant à la couche 2 une déformation préalable inverse de celle que l'on souhaite appliquer à la couche de matériau à contraindre.

Ainsi, lorsque l'on réitère l'invention, le deuxième matériau, piézoélectrique ou électrostrictif ou magnétotrictif ou photostrictif, peut être prédéformé avant l'assemblage avec le matériau à contraindre, cette prédéformation étant l'opposée de celle que l'on veut faire subir au matériau à contraindre. Une fois la couche à contraindre transférée, on relâche la sollicitation, ce qui contraint déjà une deuxième fois le matériau à contraindre. On peut appliquer ensuite la sollicitation inverse, ce qui contraint une troisième fois le matériau à contraindre.

Par exemple, dans le cas de matériaux piézoélectiques, on applique un champ de 20 MV/m aux bornes des électrodes d'une structure comportant un substrat de PZT de coefficient piézoélectrique $d_{3,1}$ de 200 pm/V, sur laquelle un film de silicium mince a été reporté. Cela contraint ce film à 0.4 %. On prend ensuite une deuxième structure comportant un matériau massif en PZT soumis à un champ de -20 MV/m, puis on transfère le film de silicium sur une électrode associée à ce deuxième substrat en PZT. On coupe la tension, ce qui dilate cette deuxième structure et augmente ainsi le paramètre de maille du silicium encore de 0.4 %. On applique ensuite un champ de 20 MV/m, ce qui augmente le paramètre de maille du silicium encore de 0.4 %. On transfère alors le silicium sur un substrat 20 de silicium oxydé, on obtient donc un sSOI avec un paramètre de maille en tension de 1.2 %.

De manière générale, la déformation du matériau piézoélectrique 2 est donnée par la relation suivante :

$$\Delta L \approx E d_{i,j} L_0$$

où $d_{i,j}$ est le coefficient piezoélectrique du matériau, E le champ appliqué en $Vm^{-1}$ et $L_0$ la déformation initiale.

Un calcul de déformation peut être réalisé dans les conditions suivantes : on considère un substrat 2, d'épaisseur 500 μm, en matériau piézoélectrique PZT, un coefficient $d_{3,1}$ de l'ordre de 200 pm/V, une tension de 10000 V appliquée entre les deux électrodes 4,6 du substrat en matériau PZT.

Le champ électrique est de 20 MV/m. Cette valeur est inférieure à la tension de claquage du PZT, qui est elle supérieure à 63 MV/m.

Il en résulte une déformation de l'ordre de 0,4 % ce qui correspond, par la technique connue sur SiGe, sensiblement à l'équivalent d'un sSi sur du SiGe (avec 20 % de Ge).

Selon un autre exemple de réalisation, le matériau piézoélectrique est du quartz.

On considère donc un substrat 2 en quartz, de 200 mm de diamètre et de 500 microns d'épaisseur. On réalise les deux électrodes 4, 6 par dépôt d'un matériau conducteur (par exemple en Au, ou en un oxyde conducteur) sur les deux faces du substrat de quartz. On réalise également le dépôt d'un oxyde. Par exemple on dépose 500 nm de Si02 par PECVD (dépôt chimique en phase vapeur assisté par plasma). On choisit une température de dépôt de l'oxyde pas trop élevée pour garantir l'intégrité des électrodes.

Eventuellement l'oxyde peut être légèrement rugosifié (par traitement chimique ou plasma) afin de réaliser un collage démontable.

La couche 10 que l'on souhaite contraindre, par exemple en silicium, et éventuellement recouverte d'une couche mince d'oxyde, par exemple thermique, est ensuite assemblée avec cette couche d'oxyde. Par exemple, à partir d'un substrat SOI, on réalise un assemblage et un collage de la couche superficielle en silicium de ce SOI éventuellement recouverte d'une couche mince d'oxyde, avec la couche d'oxyde déposée sur l'électrode. On réalise ensuite un amincissement de ce substrat SOI, pour ne laisser subsister que la couche de silicium sur une couche d'oxyde sur l'électrode du substrat piézoélectrique.

On peut éventuellement procéder à un amincissement de la couche reportée ou assemblée.

Une fois la couche 10 de silicium Si, par exemple d'épaisseur 20 nm, ou typiquement entre 5 nm et 100 nm, ainsi assemblée avec la couche d'oxyde, une tension est appliquée entre les deux électrodes 4, 6 ce qui a pour effet de mettre en tension cette couche 10 de silicium.

Le coefficient $d_{3,1}$ est ici de l'ordre de 3 pm/V, et une tension de 4000 V est appliquée aux bornes du matériau 2 (entre les deux électrodes 4, 6).

Il en résulte un champ électrique de 8 MV/m (très proche de la limite de la tension de claquage dans le quartz), et une déformation de l'ordre de 0.002 %.

La valeur de déformation obtenue est faible. Néanmoins, le quartz a l'avantage d'être un matériau massif disponible en 200 mm. Par ailleurs, comme déjà expliqué ci-dessus, il est possible de réitérer le cycle de mise sous contrainte, pour contraindre de plus en plus le silicium.

Au final, le silicium sous tension est assemblé avec un substrat 20 de silicium oxydé en surface afin d'obtenir une structure SOI, avec une couche superficielle de silicium mise sous contrainte.

Avantageusement, avant l'assemblage ou le collage, sur le matériau piézoélectrique, de la couche 10 de matériau à contraindre, on peut établir une prédéformation de la couche 2, en lui appliquant une déformation inverse à celle que l'on souhaite appliquer au matériau à contraindre. Après assemblage de la couche 10 avec le matériau piézoélectrique, la contrainte de ce dernier est relâchée pour tout ou partie, par annulation ou modification de la tension appliquée. La couche 10 se voit alors mise sous contrainte. La couche ainsi contrainte peut être assemblée avec un substrat final ou de report.

En variante, la couche 2 peut à nouveau être déformée, en lui appliquant une déformation de même signe que celle que l'on souhaite appliquer au matériau à contraindre afin d'accroître encore la contrainte de ce matériau.

En général, lors des mises sous tension, la tension de claquage de l'air de l'ordre de 3 MV/m, ne pose pas de problème. Néanmoins, si ce n'était pas le cas, il serait possible d'augmenter la valeur de la tension de claquage de l'air en en modifiant la pression, ou en modifiant la nature du gaz constituant l'atmosphère environnante, ou en mettant le système sous vide.

Le mode de réalisation selon l'invention exposé ci-dessus présente des inconvénients. Il met en oeuvre un matériau piézoélectrique massif 2 et nécessite l'application de tensions relativement élevées. Selon un autre mode de réalisation du procédé, on utilise donc, non pas un substrat massif, mais une ou des couches minces de matériau piézoélectrique, obtenue(s) par exemple par dépôt ou report sur un substrat support. Une telle couche mince, ou un ensemble de couches minces, est d'épaisseur par exemple inférieure à 200 μm ou comprise entre 1 μm et 100 μm.

Cette couche peut être disposée sur un substrat support pour former la structure sur laquelle la couche à contraindre est collée. Dans ce cas on choisit un substrat support, suffisamment souple pour permettre à la couche apte à se déformer de se déformer. Au besoin, une couche intermédiaire pourra être prévue à cet effet.

Le matériau piézoélectrique, avec son empilement d'électrodes 4, 6, est déposé ou reporté sur une couche ou un substrat support ductile 26, par exemple de type polymère (ce peut être notamment du PDMS ou du Polyvinylidene fluoride (PVDF)) afin de permettre la déformation du matériau piézoélectrique et donc la mise sous contrainte de la couche supérieure 10 Cette couche ductile permet au matériau piézoélectrique de se déformer. La référence 28 désigne un substrat support.

Dans ce cas là, les ordres de grandeur de la contrainte sont les suivants.

La déformation du matériau piézoélectrique est donnée par la même formule que celle déjà indiquée ci-dessus. On considère le même matériau PZT, avec le même coefficient $d_{3,1}$ de l'ordre de 200 pm/V.

Pour une tension appliquée de 4000 V de part et d'autre d'une couche 2 d'épaisseur 100 μm, on a un champ électrique de 40 MV/m.

Ceci conduit à une déformation de l'ordre de 0.8 % ce qui correspond sensiblement à l'équivalent d'un sSi sur du SiGe avec Ge à 20 %.

Cette valeur de contrainte peut être modulée soit par l'épaisseur de la couche 2 en matériau piézoélectrique, soit par la tension appliquée. On peut également choisir un autre matériau piézoélectrique présentant un autre coefficient $d_{3,1}$.

Par conséquent, selon ce mode de réalisation, on met en oeuvre, non pas un substrat massif de matériau piézoélectrique, mais une couche mince d'un tel matériau, d'épaisseur par exemple comprise entre 1 μm et 100 μm.

Avantageusement, on met en oeuvre une telle couche mince de matériau piézoélectrique et le substrat receveur final 20 est épais (par exemple d'épaisseur comprise entre 100 μm et 1 mm) pour que celui-ci ne se casse pas si on relâche la tension après le dernier collage.

Le fait de mettre la couche piézoélectrique mince en contrainte pourra permettre, quand on coupe la tension et donc que l'on relâche cette contrainte, d'aider au détachement du film contraint par l'application d'une contrainte mécanique au niveau de l'interface de collage avec ce film.

Chacun des exemples suivants concerne la mise en oeuvre du mode de réalisation avec non pas un substrat massif mais une couche fine, par exemple d'épaisseur 10 μm, de matériau piézoélectrique.

Dans un premier exemple de réalisation, on utilise du Quartz, matériau piézoélectrique ayant l'avantage d'être disponible en 200 mm. La structure initiale est celle de la figure 4.

La couche 26 est obtenue par dépôt de PDMS (avec recuit de densification, par exemple à 200°C pendant 2 heures) et le substrat 28 est en silicium. Les électrodes 4, 6 résultent d'un dépôt d'un matériau conducteur (par exemple en Au, ou en un oxyde conducteur).

Le Quartz est ensuite aminci, par exemple par rodage et polissage, jusqu'à une épaisseur de 10 μm. Un dépôt de matériau métallique basse température (par exemple < 200°C) est ensuite réalisé pour former la seconde électrode. Celle-ci est éventuellement recouverte d'oxyde, à basse température (par exemple un dépôt de $SiO_2$ à une température < 200°C).

Eventuellement, l'oxyde peut être légèrement rugosifié (par traitement chimique ou plasma), afin de réaliser un collage démontable.

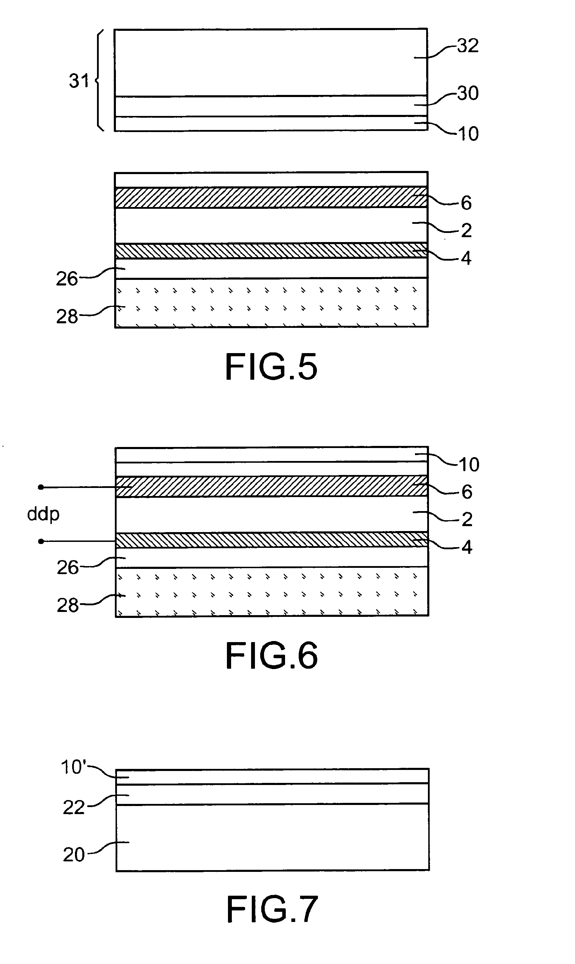

La couche que l'on souhaite contraindre (par exemple en Silicium) est ensuite reportée sur cet oxyde. Pour ce faire, on peut partir d'un SOI 31 (figure 5) puis transférer une couche 10 de silicium par collage/amincissement. On peut aussi partir d'un substrat massif, puis procéder par collage et amincissement, ou par procédé Smart Cut™, si les températures qui permettent ce type d'amincissement sont compatibles avec les couches de polymères.

On obtient dans tous les cas la structure de la figure 6.

Une fois la couche de Si de surface amincie (par exemple à 20 nm si on part d'un SOI), une tension est appliquée entre les deux électrodes, ce qui a pour effet de mettre en tension la couche de Si.

Le coefficient $d_{3,1}$ pour du quartz est de l'ordre de 3 pm/V, et une tension de 80 V est appliquée entre les électrodes 4, 6, aux bornes du matériau 2, d'épaisseur 10 μm. Il en résulte un champ électrique de 8 MV/m, et une déformation de l'ordre de 0.002 %. Ceci correspond à une contrainte obtenue avec un SiGe, avec une concentration en Ge de l'ordre de 20 %.

Cette couche de Si sous tension est ensuite reportée, tout en maintenant la tension, sur un substrat 20 en Silicium oxydé, pour obtenir un sSOI (figure 7).

Les opérations de collage - contrainte - décollage peuvent éventuellement être réalisées plusieurs fois si l'on souhaite augmenter la contrainte, comme déjà expliqué ci-dessus.

Dans un deuxième exemple de réalisation, on utilise du PZT en tant que matériau piézoélectrique. Les étapes décrites ci-dessus pour le précédent exemple de réalisation sont reproduites, sauf pour la formation de la couche 2, obtenue par dépôt de PZT sur une épaisseur de 10 μm.

Là encore, éventuellement, l'oxyde peut être rendu légèrement rugueux (par traitement chimique ou plasma), afin de réaliser un collage démontable.

La couche que l'on souhaite contraindre (par exemple en Silicium) est ensuite assemblée avec cet oxyde. Pour ce faire, là aussi, on peut partir d'un SOI 30 (figure 5) ou d'un substrat massif, en mettant en oeuvre l'une des techniques mentionnées dans l'exemple précédent.

On obtient, dans tous les cas, la structure de la figure 6.

On met ensuite sous contrainte la couche de Si. Le coefficient $d_{3,1}$ pour du PZT est de l'ordre de 200 pm/V, et une tension de 400 V est appliquée entre les électrodes 4, 6, aux bornes du matériau 2, d'épaisseur 10 μm. Il en résulte un champ électrique de 40 MV/m, et une déformation de l'ordre de 0.8 %. Ceci correspond grossièrement à une contrainte obtenue dans un film de sSi avec un SiGe à une concentration en Ge de l'ordre de 20 %.

Le Si sous tension peut être ensuite assemblé, tout en maintenant la tension, avec un substrat 20 en Si oxydé par exemple, pour obtenir un sSOI (figure 7).

Les opérations de collage - contrainte - décollage peuvent éventuellement être réalisées plusieurs fois si l'on souhaite augmenter la contrainte, comme déjà expliqué ci-dessus.

Les exemples décrits ci-dessus concernent une couche de matériau piézoélectrique, apte à se déformer sous l'effet d'un champ électrique.

La même description vaut pour une couche de matériau électrostrictif, se déformant également sous l'effet d'un champ électrique. Ce dernier est appliqué par deux électrodes, situées de part et d'autre de la couche de matériau électrostrictif. La structure de mise sous contrainte est donc identique ou similaire à celle déjà décrite ci-dessus. Le mode de réalisation, déjà décrit ci-dessus, avec couche mince, reste valable pour ce type de matériau. Les gammes d'épaisseurs sont toujours valables : une telle couche mince, ou un ensemble de couches minces, est d'épaisseur par exemple inférieure à 200 μm ou comprise entre 1 μm et 100 μm.

Un procédé de mise sous contrainte est identique ou similaire à l'un de ceux déjà décrits ci-dessus.

La couche 10 est assemblée, par exemple par collage moléculaire, avec une électrode du substrat ou de la couche en matériau électrostrictif, d'une des manières décrites ci-dessus en liaison avec les figures 1A, 1B, 5-6, 8A-8C.

On peut citer, comme exemple de matériau électrostrictif, les matériaux suivants :

- composés de type niobate de plomb-magnésium (PMN),
- composés de type niobate de plomb-magnésium et titanate de plomb (PMN-PT),
- composés de type titanate de plomb-magnésium-zirconium (PLZT).

L'invention et toutes ses variantes décrites ci-dessus s'applique aussi à une couche en un matériau magnétostrictif.

Dans ce cas, on n'a pas à prévoir d'électrodes pour l'application d'un champ électrique. C'est, cette fois, l'application d'un champ magnétique qui entraîne la déformation du matériau magnétostrictif, qui entraîne à son tour la mise sous contrainte de la couche assemblée. Parmi les matériaux magnétostrictifs, on peut citer le cobalt et le TerFeNol-D (Ter pour terbium, Fe pour fer, NOL pour Naval Ordnance Laboratory, D pour dysprosium), de formule $Tb_x Dy_{1-x} Fe_2$.

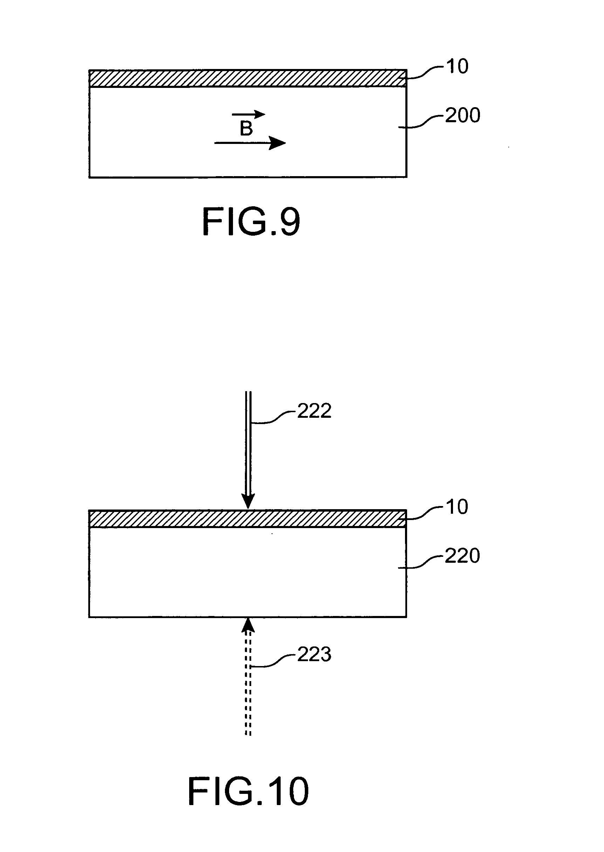

La figure 9 représente un assemblage, par exemple par collage moléculaire, d'une couche 200 de matériau magnétostrictif et d'une couche 10 à contraindre. Cette dernière peut être obtenue d'une des manières décrites ci-dessus en liaison avec les figures 1A, 1B, 5-6, 8A-8C. Un champ magnétique B, est appliqué à l'aide de moyens pour générer un tel champ. Ces moyens ne sont pas représentés sur la figure. L'interaction de ce champ B avec la matière de la couche 200 déforme cette dernière. Le mode de réalisation, déjà décrit ci-dessus, avec couche mince, reste valable pour ce type de matériau. Les gammes d'épaisseurs sont toujours valables : une telle couche mince, ou un ensemble de couches minces, est d'épaisseur par exemple inférieure à 200 $\mu$m ou comprise entre 1 $\mu$m et 100 $\mu$m.

Selon un exemple de réalisation, le matériau magnétostrictif est du Terfelon-D (Tb0.3Dy0.7Fe1.9).

On considère donc un substrat 2 en Terfelon-D, de 200 mm de diamètre et de 500 $\mu$m d'épaisseur. On dépose éventuellement sur ce substrat un oxyde pour servir de couche de collage. L'oxyde peut être légèrement rugosifié (par traitement chimique ou plasma) afin de réaliser un collage démontable.

La couche que l'on souhaite contraindre, en silicium par exemple, est ensuite assemblée avec cette couche d'oxyde. Par exemple, à partir d'un substrat SOI, on réalise un assemblage et un collage de la couche superficielle en silicium de ce SOI avec la couche d'oxyde. On réalise ensuite un amincissement de ce substrat SOI pour ne laisser subsister que la couche de silicium (et éventuellement la couche d'oxyde) sur la couche d'oxyde du substrat magnétostrictif.

On peut éventuellement procéder à un amincissement de la couche reportée.

Une fois la couche de silicium Si, par exemple d'épaisseur 20 nm (comprise entre 5 nm et 100 nm, préférentiellement d'environ 20 nm), assemblée avec la couche d'oxyde, un champ magnétique (perpendiculaire à la plaquette de Terfelon-D) est appliqué à l'ensemble de la structure, ce qui a pour effet de contracter le Terfelon-D dans le plan de la plaquette et a donc pour effet de mettre en compression la couche de silicium. Avec un $\Delta L/L$ de $5.10^{-4}$, on obtient une déformation de 0.05 %.

Il est possible de réitérer cette opération et/ou également de précontraindre le matériau magnétostrictif avant le collage moléculaire.

L'invention et toutes ses variantes décrites ci-dessus s'applique aussi à une couche 220 en un matériau photostrictif, comme illustré sur la figure 10.

Dans ce cas encore, on n'a pas à prévoir d'électrodes pour l'application d'un champ électrique.

C'est, cette fois, l'application d'un flux de photon 222 sur ce matériau qui entraîne sa déformation dans le plan de la couche 220, qui entraîne à son tour la mise sous contrainte de la couche 10 assemblée par collage moléculaire avec le substrat 220.

Le flux de photons incident 222, provenant d'une source de rayonnement non représentée sur la figure, peut être dirigé à travers la couche 10 à contraindre si celle-ci est transparente (cas de la figure 10), ou par la face opposée du substrat 220 (faisceau 223; auquel cas on utilise un substrat support 220 en matériau photostrictif transparent ou semi-transparent). Cette couche 10 peut être obtenue d'une des manières décrites ci-dessus en liaison avec les figures 1A, 1B, 5-6, 8A-8C.

Parmi les matériaux photostrictifs, on peut citer la céramique PLZT (composition déjà indiquée ci-dessus), ou un cristal de type PMN-PT (composition déjà indiquée ci-dessus) dopé au Tungstène, ou de type niobate de plomb - zirconium et titanate de plomb (PZN-PT).

Le mode de réalisation, déjà décrit ci-dessus, avec couche mince, reste valable pour ce type de matériau. Les gammes d'épaisseurs sont toujours valables : une telle couche mince, ou un ensemble de couches minces, est d'épaisseur par exemple inférieure à 200 $\mu$m ou comprise entre 1 $\mu$m et 100 $\mu$m.

Un procédé de mise sous contrainte avec un système de mise sous contrainte à base de matériau photostrictif est identique ou similaire à l'un de ceux déjà décrits ci-dessus.

Dans les trois autres exemples mentionnés ci-dessus (matériau électrostrictif ou magnétostrictif ou photostrictif), il peut y avoir application successive d'une contrainte, comme déjà expliqué dans le cas du matériau piézoléctrique. En outre le substrat peut être mis initialement sous précontrainte (application d'une contrainte de signe opposé à la contrainte que l'on souhaite appliquer à la couche à contraindre), la précontrainte est ensuite relâchée après assemblage de la couche 10 avec le substrat.

Dans le cas d'un matériau magnéto-strictif ou photo-strictif, on peut appliquer une précontrainte de signe opposé comme dans le cas des autres matériaux.

Par exemple, l'application d'un champ ou de photons fait contracter le matériau. Si on colle ou on assemble une couche sur un substrat ou une couche de ce matériau avant l'application de la contrainte, on réalise une compression. Si on colle ou on assemble après la mise sous contrainte, on réalise une mise en tension lors du relâchement de la sollicitation.

## Revendications

1. Procédé de réalisation d'une couche contrainte sur un substrat de report, comportant :

   a) l'assemblage, de cette couche (10) à contraindre, avec une première structure, ou des premiers moyens, de mise sous contrainte, comportant au moins un substrat ou une couche (2, 200, 220) apte à se déformer dans son plan sous l'effet d'un champ électrique ou magnétique ou d'un flux de photons,
   b) la mise sous contrainte de ladite couche (10) par modification du champ électrique ou magnétique ou du flux de photons appliqué au substrat ou à la couche apte à se déformer.
   c) un assemblage de ladite couche contrainte (10) avec un substrat, dit substrat de report (20),
   d) une élimination de tout ou partie de la première structure de mise sous contrainte.

2. Procédé selon la revendication 1, l'assemblage de ladite couche (10) avec la première structure de mise sous contrainte étant obtenu par assemblage de cette première structure avec un substrat (100), puis amincissement de ce substrat.

3. Procédé selon la revendication précédente, l'amincissement étant de type mécanique, ou étant réalisé par fracture du substrat (100) le long d'une zone (104) de fragilisation, ou par amincissement mécanique et/ou chimique jusqu'à une couche d'arrêt (105).

4. Procédé selon l'une des revendications 2 ou 3, l'amincissement étant réalisé à partir d'un substrat de type SOI.

5. Procédé selon l'une des revendications précédentes, comportant :

   - avant l'étape a), une précontrainte, par mise sous contrainte de la première structure de mise sous contrainte, de signe opposé à la contrainte que l'on souhaite appliquer à la couche (10) à contraindre,
   - après l'étape a), une relaxation de la précontrainte, pour contraindre la couche (10) à contraindre.

6. Procédé selon l'une des revendications précédentes, au moins une des étapes d'assemblage étant réalisée par collage moléculaire,

7. Procédé selon l'une des revendications précédentes, l'assemblage de ladite couche (10) avec la première structure de mise sous contrainte étant plus faible que l'assemblage entre la couche contrainte (10) et le substrat (20) de report.

8. Procédé selon l'une des revendications 1 à 7, le substrat (20) de report comportant une couche (22) d'oxyde superficielle.

9. Procédé selon l'une des revendications 1 à 8, le substrat (20) de report étant en silicium et comportant une couche (22) d'oxyde de silicium superficielle, ladite couche à contraindre étant en silicium.

10. Procédé selon l'une des revendications 1 à 9, comportant ensuite :

    a') un report de la couche contrainte, depuis le substrat de report (20) vers la première ou vers une deuxième structure de mise sous contrainte,
    b') une mise sous contrainte supplémentaire de ladite couche contrainte (10) par la première ou par cette deuxième structure de mise sous contrainte.

11. Procédé selon l'une des revendications 1 à 10, le substrat de report formant ou comportant une deuxième structure de mise sous contrainte, le procédé comportant en outre une mise sous contrainte supplémentaire de ladite couche contrainte (10) par cette deuxième structure de mise sous contrainte.

12. Procédé selon l'une des revendications 10 ou 11, la deuxième structure de mise sous contrainte, comportant au moins un substrat ou une couche apte à se déformer dans son plan sous l'effet d'un champ électrique ou magnétique ou d'un flux de photons, la mise sous contrainte supplémentaire comportant la mise sous contrainte de ladite couche (10) par modification du champ électrique ou magnétique ou du flux de photons appliqué au substrat ou à la couche apte à se déformer.

13. Procédé selon l'une des revendications précédentes, la première structure de mise sous contrainte et/ou la deuxième structure de mise sous contrainte mettant en oeuvre un substrat ou une couche de matériau piézoélectrique ou électrostrictif ou magnétotrictif ou photostrictif, d'épaisseur supérieure à 200 µm ou comprise entre 200 µm et 500 µm ou 1 mm ou d'épaisseur comprise entre 1 µm et 50 µm ou 200 µm.

**14.** Procédé selon l'une des revendications 1 à 13, ladite couche à contraindre étant en un matériau semi-conducteur.

**15.** Procédé selon l'une des revendications 1 à 14, la première et/ou la deuxième structure de mise sous contrainte, comportant :

    - un substrat ou une couche en matériau piézoélectrique et des électrodes associées, disposées de part et d'autre de ce substrat ou de cette couche,
    - ou un substrat ou une couche en matériau électrostrictif et des électrodes associées, disposées de part et d'autre de ce substrat ou de cette couche,
    - ou un substrat ou une couche en matériau magnétostrictif,
    - ou un substrat ou une couche en matériau photostrictif.

**Claims**

**1.** Method of producing a strained layer on a substrate, comprising:

    a) the assembly of this layer (10) with a first straining structure, or a first straining layer, comprising at least one substrate or layer (2, 200, 220) capable of being deformed within the plane thereof under the influence of an electric or magnetic field or a photon flux,
    b) the straining of said layer (10) by modifying the electric or magnetic field or the photon flux applied to the deformable substrate or layer,
    c) assembly of said strained layer (10) with a substrate, referred to as a transfer substrate,
    d) removal of all or part of the first straining structure.

**2.** Method according to claim 1, the assembly of said layer (10) with the first straining structure being obtained by assembly of this first structure with a substrate (100), and then a thinning out of this substrate.

**3.** Method according to the preceding claim, the thinning out being of the mechanical type, or being carried out by fracturing the substrate (100) along an embrittlement region, or by mechanically and/or chemically thinning out as far as a stop layer (105).

**4.** Method as claimed in claim 2 or 3, the thinning out being carried out starting with an SOI-type substrate.

**5.** Method according to any of the preceding claims, comprising:

    - prior to step a), pre-straining, via straining of the first straining structure, with a prestrain having an opposite sign of that to be applied to the layer (10) to be strained,
    - after step a), relaxation of the prestrain, in order to strain the layer (10) to be strained.

**6.** Method according to one of the preceding claims, at least one of the assembly steps being carried out via molecular bonding.

**7.** Method according to one of the preceding claims, the assembly of said layer (10) with the first straining structure being weaker than the assembly between the strained layer (10) and the transfer substrate (20).

**8.** Method according to any of claims 1 to 7, the transfer substrate comprising an oxide surface layer (27).

**9.** Method according to any of claims 1 to 8, the transfer substrate (20) being made of silicon and comprising a silicon oxide surface layer (22), said layer to be strained being made of silicon.

**10.** Method according to any of claims 1 to 9, next comprising:

    a') a transfer of the strained layer from the transfer substrate (20) towards the first one or towards a second straining structure,
    b') an additional straining of said strained layer (10) via the first one or via this second straining structure.

**11.** Method according to any of claims 1 to 10, the transfer substrate forming or comprising a second straining structure, the method further comprising an additional straining of said strained layer (10) by this second straining structure.

**12.** Method as claimed in claim 10 or 11, said second straining structure comprising at least one substrate or one layer capable of being deformed within the plane thereof under the influence of an electric or magnetic field or a photon flux, the additional straining comprising the straining of said layer by modifying the electric or magnetic field or the photon flux applied to the deformable substrate or deformable layer.

**13.** Method according to any of the preceding claims, the first straining structure and/or the second straining structure implementing a substrate or a layer of a piezoelectric or electrostrictive or magnetostrictive or photostrictive material, having a thickness greater than 200 μm or between 200 μm and 500 μm or 1 mm or having a thickness of between 1 μm and 50 μm or 200 μm.

**14.** Method according to any of claims 1 to 13, said layer to be strained being made of a semiconductor material.

**15.** Method according to any of claims 1 to 14, the first and/or the second straining structure:

- comprising a substrate or a layer made of a piezoelectric material and associated electrodes arranged on both sides of this substrate or this layer;
- or a substrate or a layer made of an electrostrictive material and associated electrodes arranged on both sides of this substrate or this layer;
- or a substrate or a layer made of a magnetostrictive material;
- or a substrate or a layer made of a photostrictive material.

**Patentansprüche**

**1.** Verfahren zur Herstellung einer gespannten Schicht auf einem Übertragungssubstrat, umfassend:

a) das Zusammenfügen dieser zu spannenden Schicht (10) mit einer ersten Struktur oder ersten Mitteln zum Spannung-Setzen, umfassend wenigstens ein Substrat oder eine Schicht (2, 200, 220), das/die dazu ausgelegt ist, sich unter dem Einfluß eines elektrischen oder magnetischen Felds oder eines Photonenflusses in seiner/ihrer Ebene zu verformen,
b) das Spannung-Setzen der Schicht (10) durch Modifizieren des elektrischen oder magnetischen Felds oder des Photonenflusses, das/der an das Substrat oder an die Schicht angelegt wird, das/die dazu ausgelegt ist, sich zu verformen,
c) ein Zusammenfügen der gespannten Schicht (10) mit einem Substrat, genannt Übertragungssubstrat (20),
d) eine Entfernung der gesamten ersten Struktur zum Spannung-Setzen oder eines Teils davon.

**2.** Verfahren nach Anspruch 1, wobei das Zusammenfügen der Schicht (10) mit der ersten Struktur zum Spannung-Setzen erzielt wird durch Zusammenfügen dieser ersten Struktur mit einem Substrat (100) und anschließendes Dünnermachen dieses Substrats.

**3.** Verfahren nach dem vorhergehenden Anspruch, wobei das Dünnermachen vom mechanischen Typ ist oder durch Brechen des Substrats (100) entlang einer Schwächungszone (104) erfolgt oder durch mechanisches und/oder chemisches Dünnermachen bis zu einer Halteschicht (105).

**4.** Verfahren nach einem der Ansprüche 2 oder 3, wobei das Dünnermachen ausgehend von einem Substrat vom SOI-Typ erfolgt.

**5.** Verfahren nach einem der vorgehenden Ansprüche, umfassend:

- vor dem Schritt a), ein Vorspannen durch Spannung-Setzen der ersten Struktur zum Spannung-Setzen mit einem Vorzeichen, das der Spannung entgegengesetzt ist, die man auf die zu spannende Schicht (10) ausüben möchte,
- nach dem Schritt a), eine Entspannung der Vorspannung, um die zu spannende Schicht (10) zu spannen.

**6.** Verfahren nach einem der vorhergehenden Ansprüche, wobei wenigstens einer der Zusammenfügeschritte durch molekulares Kleben erfolgt.

**7.** Verfahren nach einem der vorhergehenden Ansprüche, wobei die Zusammenfügung der Schicht (10) mit der ersten Struktur zum Spannung-Setzen schwächer ist als die Zusammenfügung zwischen der gespannten Schicht (10) und dem Überfiragungssubstrat (20).

**8.** Verfahren nach einem der Ansprüche 1 bis 7, wobei das Übertragungssubstrat (20) eine Oberflächenoxydschicht (22) umfasst.

**9.** Verfahren nach einem der Ansprüche 1 bis 8, wobei das Übertragungssubstrat (20) aus Silicium ist und eine Oberflächen-Siliciumoxydschicht (22) umfasst, wobei die zu spannende Schicht aus Silicium ist.

**10.** Verfahren nach einem der Ansprüche 1 bis 9, anschließen umfassend:

a') eine Übertragung der gespannten Schicht vom Übertragungssubstrat (20) hin zur ersten oder hin zu einer zweiten Struktur zum Spannung-Setzen,
b') ein zusätzliches Spannung-Setzen der gespannten Schicht (10) durch die erste oder durch diese zweite Struktur zum Spannung-Setzen.

**11.** Verfahren nach einem der Ansprüche 1 bis 10, wobei das Übertragungssubstrat eine zweite Struktur zum Spannung-Setzen bildet oder umfasst, wobei das Verfahren ferner ein zusätzliches Spannung-Setzen der gespannten Schicht (10) durch diese zweite Struktur zum Spannung-Setzen umfaßt.

**12.** Verfahren nach einem der Ansprüche 10 oder 11, wobei die zweite Struktur zum Spannung-Setzen wenigstens ein Substrat oder eine Schicht umfasst, das/die dazu ausgelegt ist, sich unter dem Einfluss eines elektrischen oder magnetischen Feldes oder eines Photonenflusses in seiner/ihrer Ebene zu verformen, wobei das zusätzliche Spannung-Setzen das Spannung-Setzen der Schicht (10) durch Modifizierung des elektrischen oder magnetischen Felds oder des Photonenflusses umfasst, das/der auf das Substrat oder auf die Schicht ausgeübt wird, das/die dazu ausgelegt ist, sich zu verformen.

**13.** Verfahren nach einem der vorhergehenden Ansprüche, wobei die erste Struktur zum -Spannung-Setzen und/oder die zweite Struktur zum Spannung-Setzen ein Substrat oder eine Schicht aus piezoelektrischem oder elektrostriktivem oder magnetostriktivem oder photostriktivem Material verwendet, dessen Dicke größer als 200 $\mu$m oder zwischen 200 $\mu$m und 500 $\mu$m oder 1 mm enthalten ist, oder dessen Dicke zwischen 1 $\mu$m und 50 $\mu$m oder 200 $\mu$m enthalten ist.

**14.** Verfahren nach einem der Ansprüche 1 bis 13, wobei die zu spannende Schicht aus einem Halbleitermaterial ist.

**15.** Verfahren nach einem der Ansprüche 1 bis 14, wobei die erste und/oder die zweite Struktur zum Spannung-Setzen umfassen:

> - ein Substrat oder eine Schicht aus piezoelektrischem Material sowie zugeordnete Elektroden, die auf beiden Seiten dieses Substrats oder dieser Schicht angeordnet sind,
> - oder ein Substrat oder eine Schicht aus elektrostriktivem Material sowie zugeordnete Elektroden, die auf beiden Seiten dieses Substrats oder dieser Schicht angeordnet sind,
> - oder ein Substrat oder eine Schicht aus magnetostriktivem Material,
> - oder ein Substrat oder eine Schicht aus photostriktivem Material.

FIG.1A

FIG.1B

FIG.1C

FIG.2

FIG.3

FIG.4

## FIG.5

## FIG.6

## FIG.7

FIG.8A

FIG.8B

FIG.8C

10

200

$\vec{B}$

# FIG.9

222

10

220

223

# FIG.10

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20030199105 A

**Littérature non-brevet citée dans la description**

- **B. Aspar ; A.J. Auberton-Hervé.** Silicon Wafer Bonding Technology for VLSI and MEMS applications. 2002, 35-52
- **Q.Y. Tong.** Silicon Wafer Bonding Technology for VLSI and MEMS applications. 2002, 1-20
- ESTRAN® by Splitting Porous Si layers. **K. Sataguchi et al.** Proceedings of the 9th International Symposium on Silicon-on-Insulator Tech. and Device. The Electrochemical Society, 1999, 117-121